# EUROPEAN PATENT SPECIFICATION

(11) **EP 1 821 572 B1**
(45) Date of publication and mention of the grant of the patent: **28.11.2012**
(21) Application number: 06003376.8
(22) Date of filing: 20.02.2006
(51) Int. Cl.: H04R 27/00

(54) **Sound system**
Audiosystem
Système audio

(43) Date of publication of application: 22.08.2007
(73) Proprietor: Harman Becker Automotive Systems GmbH, 76307 Karlsbad (DE); Dr. Ing. h.c. F. Porsche AG, 70435 Stuttgart (DE)
(72) Inventor: Zeller, Michael, 76307 Karlsbad (DE); Hess, Wolfgang, 76307 Karlsbad (DE); Nitzpon, Hans-Jürgen, Dr., 76337 Waldbronn (DE); Renz, Matthias, 71737 Weissach (DE)
(74) Representative: Bertsch, Florian Oliver

(56) References cited:
- US-A1- 2005 195 994
- PATENT ABSTRACTS OF JAPAN vol. 2000, no. 09, 13 October 2000 (2000-10-13) & JP 2000 161977 A (ALPINE ELECTRONICS INC), 16 June 2000 (2000-06-16)

## Description

This invention relates to a sound system comprising an entertainment sound source and an announcement sound source and to a method for adjusting the sound level of the announcement sound signal relative to the sound level of the entertainment sound signal. The invention finds especially application in vehicles, where multimedia systems are used comprising a navigation module and an audio module such as a radio receiver, compact disc unit, etc.

Motor vehicle navigation systems as such have been known for a relatively long time and are increasingly offered in new vehicles or retrofitting purposes. In this context the navigations are used to guide the driver of the vehicle from the present location to a destination location. In many systems the guiding is done by announcing to the driver how to behave at an upcoming location. By way of example a navigation system may alert the driver that he has to turn right at the next traffic light (e.g. "turn right in two hundred meters").

Often the driver is using an audio source such as a radio or a compact disc together with the guiding of the navigation system. In case of an announcement by the navigation system the announcement sound signal is mixed to the sound signal of the other audio source which is called entertainment sound source in the present application. In this case it may happen that the sound level of the announcement sound signal relative to the sound level of the entertainment sound signal is chosen in such a way that the announcement sound level may be considered by the driver as being too high or too low relative to the other sound source, the entertainment sound signal. It may happen that the driver is listening to a piece of music containing rock music and that an announcement sound signal is mixed to the entertainment sound signal which is considered as being too low. The driver may then in this case increase the sound level of the announcement sound signal. If the driver then hears a piece of music containing classical music the offset of the sound level of the announcement sound signal relative to the entertainment signal may be considered by the driver as being too high.

Summarizing in the sound systems of the prior art the sound level of the announcement sound signal relative to the entertainment sound signal was a fixed static value which could be adjusted by the user. However, due to this fixed offset, situations occur, in which the subjective judged loudness level is too high or too low.

JP 2000161977 discloses a navigation system, in which the guide sound volume is adapted in dependence on the audio signal level.

US 2005/0195994 A1 discloses an apparatus, in which the gain of a voice is controlled based on a sound pressure level of the voice and the sound pressure level of the noise.

Accordingly, a need exists for adapting the signal levels of the entertainment sound signal and of the announcement sound signal relative to each other in such a way that the announcement can be understood irrespective of the level of the entertainment sound signal.

This need is met by a method for adjusting the sound level and by a sound system as mentioned in the independent claims. In the dependent claims preferred embodiments of the invention are described.

In accordance with an exemplary embodiment of the invention the sound system comprises an entertainment sound source generating the entertainment sound signal. Furthermore, an announcement sound source generating an announcement sound signal is provided. Both the announcement sound signal and the entertainment sound signal are emitted by a sound emitting unit for reproducing the entertainment and the announcement sound signal. The entertainment sound may be any kind of audio sound provided on a storage medium such as a CD, DVD, MP3 player as well as players supporting other formats or a radio receiver. The announcement sound source may comprise any sound sources generating an announcement. The announcement may be part of a guiding system of a navigation system or may be part of any other vehicle control system in which speech signals are used to inform the driver. The announcement may be an announcement warning the driver of an upcoming event or informing the driver of any other situation the driver should get notice of (e.g. when a certain part of the vehicle does not function properly any more). Additionally, a loudness determination unit is provided determining the loudness evolution of the entertainment sound signal in time. A control unit is provided for adjusting the loudness of the announcement sound signal relative to the loudness of the entertainment sound signal in accordance with the determined loudness evolution of the entertainment sound signal. When the loudness evolution of the entertainment sound level is known the announcement sound signal can be adjusted depending on the entertainment sound signal. It is possible only to adjust the announcement sound signal itself, however it is also possible to adjust the loudness of both the announcement sound signal and of the entertainment sound signal. By way of example in the case of a very loud piece of music the loudness of the entertainment sound signal may be lowered, and the loudness of the announcement sound signal may be determined in such a way that the entertainment sound signal does not mask the announcement sound signal and that the user can understand the content of the announcement. The subjective loudness level of the announcement sound signal can be determined in an optimum way depending on the volume adjustment of the entertainment signal. A clear differentiation between the sound event (= physical domain) and the auditory event (= perceptual domain humans) is necessary to understand the need of the present application.

The sound pressure level (SPL) is a physical measure and is mathematically converted to decibel (dB). For an aurally adequate rating a weighting function (A- or C-weighting) was introduced. However, these correction curves are of a static nature. Sounds are constantly attenuated or amplified, only depending on their frequency but independent of the SPL. At big SPL differences this weighting fails.

Sound events are perceived by humans not proportional to their physical sound pressure level. Depending on temporal and spectral masking, frequency and overall sound pressure level, the loudness of the auditory event differs from the SPL of the sound events. It is measured in Sone.

For an exact aurally adequate loudness correction, a calculation of the loudness of both, the entertainment and the announcement sound signal, is necessary. This is the idea behind the invention.

Depending on the available processing power, a downscaled Zwicker loudness-model according to DIN 45631 and ISO 532 B is applied.

For calculating the maximum and the mean power of the entertainment sound signal an entertainment signal power measurement unit may be provided which detects the maximum power of the entertainment sound signal and calculates the mean power of the signal, these values being used for calculating an index and an announcement gain offset. The index represents an average loudness of the entertainment sound signal.

In this signal power measurement unit the determined signal power is converted into a loudness value in accordance with the Zwicker model mentioned above.

Preferably the system further comprises an announcement gain determination unit determining an announcement gain of the announcement sound signal based on the index, this index representing the average loudness level of the entertainment sound signal. Together with the volume adjustment adjusted at a volume control of the sound system the index helps to determine the exact announcement gain offset. The announcement gain offset determination unit may comprise a look-up table, in which for each index and for each adjusted volume, a predetermined announcement gain can be calculated.

Furthermore, the index takes into account the loudness evolution in time of the entertainment sound signal and represents the average loudness of the entertainment sound signal. This calculation of the loudness evolution in time can be based on an approximation procedure, as the calculation of the loudness according to DIN may be too complicated.

According to a preferred embodiment of the invention the average loudness of the entertainment sound signal may be calculated based on a maximum and a mean power of the entertainment sound signal. The signal level of the entertainment signal is calculated and an average signal level is determined. This average signal level helps to avoid that the index which is used for calculating the announcement gain offset is modulated by short time signal peaks in the entertainment signal, such as beats from a drummer. If no averaging were made the announcement would be modulated in accordance with the beat. By calculating the average loudness this situation can be avoided.

As described above, the announcement gain offset was determined on the basis of the index and of the adjusted volume. By turning the volume control of a sound system the sound level is changed in a predetermined way. Additionally, a value describing the gain of the announcement sound signal is used, the announcement gain representing the volume in another way. According to a preferred embodiment of the invention a first adder is provided in which the announcement gain offset is added to said announcement gain, and an adapted announcement gain is generated.

Last but not least the adapted announcement gain is mixed to the announcement sound signal itself in a first mixer.

The above-described components allow a signal processing of the announcement signal in such a way that the announcement sound signal has an adapted loudness relative to the entertainment signal. However, the entertainment signal itself may also be adjusted as described below.

According to another embodiment of the invention an entertainment gain determination unit is provided determining an entertainment gain offset of the entertainment sound signal on the basis of the volume adjustment of the entertainment sound signal. In accordance with the announcement signal the entertainment gain offset is added to an entertainment gain for generating an adapted entertainment gain in a second adder. The adapted entertainment gain is then mixed to the entertainment sound signal in a second mixer. Furthermore, a third adder may be provided in which the output signals of the first and of the second mixer are combined for generating the audio output for the user of the sound system. In this audio output the signal levels of the two signals are adjusted relative to each other in such a way that the user can understand the announcement, but is not judged as being too loud. The entertainment gain offset may be a positive or negative value.

Preferably the entertainment sound signal comprises a sound signal from at least one of the following sound sources, optical or magnetic or silicon-based media and storage devices or a broadcast receiver. The optical storage devices comprise media such as a CD, DVD, SACD, Blu-Ray disc, etc.

Magnetic storage devices comprises hard discs and silicon storage devices comprise an USB stick, memory card, flash card, multi-media card, etc.

The announcement sound signal may be a speech output or any acoustic output or voice prompts from a speech dialogue system, or from a text-to-speech system. The user may wish that the text-to-speech system reads an e-mail to the user of the system. The announcement sound signal may further be an announcement of a navigation system or may be an announcement concerning traffic indications such as TIM, or may be an announcement concerning the operating state of the vehicle including a warning for the user of the vehicle.

The invention further relates to a method for adjusting the loudness of this announcement sound signal relative to the loudness of the entertainment sound signal. According to this method the presence of an announcement sound signal may be detected in a first step. Additionally, the loudness evolution of the entertainment sound signal in time may be determined, and the loudness of the entertainment sound signal is adjusted relative to the loudness of the announcement sound signal in accordance with the loudness of the entertainment sound signal. For determining the loudness evolution of the entertainment sound signal the following steps may be carried out. First of all, the loudness evolution in time of the entertainment sound signal is taken into account by approximating the average loudness. By way of example the maximum and the mean power of the entertainment sound signal may be determined. On the basis of the maximum and the mean power and on the basis of the signal evolution of the entertainment sound signal in time an index is calculated representing the average loudness of the entertainment sound signal. The index is then used to determine the announcement gain offset. For the calculation of this corrected value the volume adjustment of the entertainment sound signal is furthermore determined.

In addition to the announcement gain offset the entertainment gain offset of the entertainment sound signal may be determined in accordance with the volume adjustment of the entertainment sound signal. To this end a table may be provided comprising entertainment gains versus volume entries. This offset may be a positive or a negative offset. This entertainment gain offset is then added to an entertainment gain for generating the adapted entertainment gain. In a corresponding manner the announcement gain offset is added to an announcement gain for generating the adapted announcement gain.

According to the invention the signal-to-noise-ratio of the announcement sound signal relative to the entertainment sound signal decreases with increasing sound level of the entertainment sound. This means that the level difference between the entertainment sound and the announcement sound decreases with increasing signal level of the entertainment sound. The announcement sound signal is adjusted in such a way that it comprises a minimum sound level up to a first threshold of the entertainment sound level. This means that the announcement sound signal has a minimum loudness at very low entertainment signal levels. This is to ensure that the driver will understand the announcement from the announcement signal source even when the entertainment sound signal is very low. After the first threshold the sound level increases with the entertainment sound level, the slope of the announcement sound signal being smaller than the slope of the entertainment sound signal. As explained above this is due to the fact that the signal-to-noise-ratio is larger for smaller entertainment sound signal levels and becomes smaller for larger sound levels. Above a second threshold value of the entertainment sound signal the announcement sound signal has a constant maximum sound level which is used when the entertainment sound signal is at maximum volume.

According to another embodiment of the invention the signal level of the entertainment signal is not kept at the signal level corresponding to the adjusted volume, when an announcement sound signal is output together with the entertainment sound signal. The sound level of the entertainment sound signal may be lowered relative to the adjusted value. The more the volume of the entertainment sound signal is increased the more the entertainment sound signal is lowered, when an announcement is output together with the entertainment signal.

Preferred embodiments of the invention are explained in more detail herein with reference to the accompanying drawings, in which
Fig. 1 is schematic view of a sound system incorporating features of the invention,
Fig. 2 is a more detailed schematic view of a sound system having adjusted entertainment and announcement signal components,
Fig. 3 is a flowchart showing the different steps for adjusting the signal output,
Figs. 4 and 5 show a flowchart for adjusting the output signal, and
Fig. 6 shows a graph of the signal level of the entertainment and the announcement sound signal in dependence on the adjusted volume.

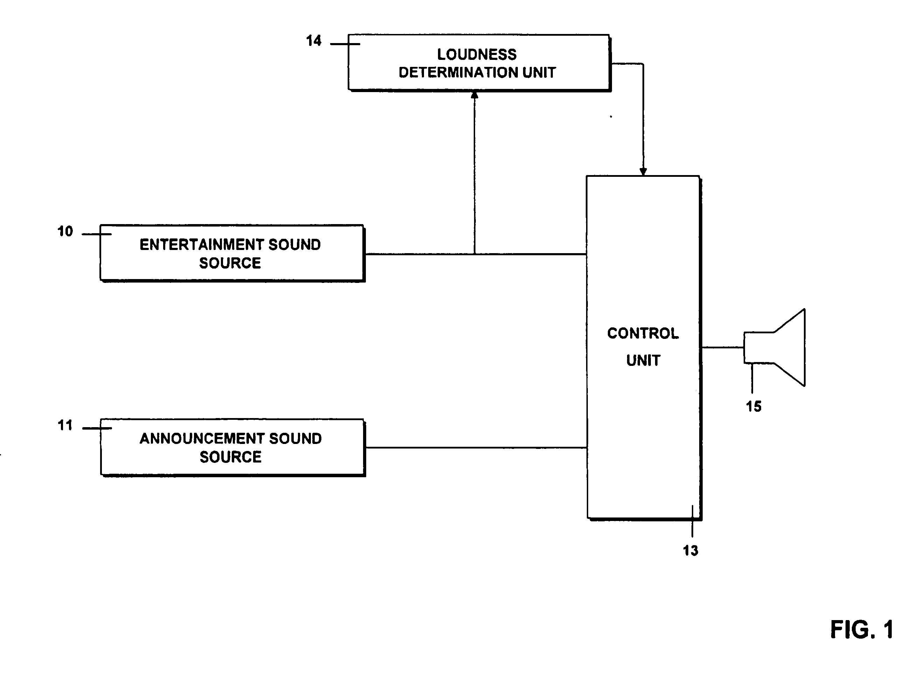

In Fig. 1 a schematic view of a sound system comprising different sound sources is shown. The sound system of Fig. 1 can be part of a multimedia system of a vehicle comprising different modules such as a navigation unit, a radio receiver, an MP3 player, a CD player, etc. The system shown in Fig. 1 may also comprise a vehicle control device emitting speech signals, the announcement of the control unit informing the driver of a certain event, be it the information that the fuel is nearly empty or be it any other information concerning the functioning of any other feature of the vehicle.

The system of Fig. 1 comprises at least an entertainment sound source or entertainment audio source 10 and an announcement sound source 11. The entertainment sound source outputs an entertainment sound signal, the announcement sound source outputting an announcement sound signal if needed. Both signals are fed to a main control unit 13. Additionally, an entertainment loudness determination unit 14 is provided which determines the loudness of the entertainment sound signal. The determined loudness of the entertainment signal is also fed to the control unit 13. The control unit mixes these two signal and outputs a combined audio output signal which is output via a loudspeaker 14. In the control unit the loudness of the entertainment sound signal is adjusted to the loudness of the announcement sound signal in such a way that the announcement information is provided in a clear way to the user.

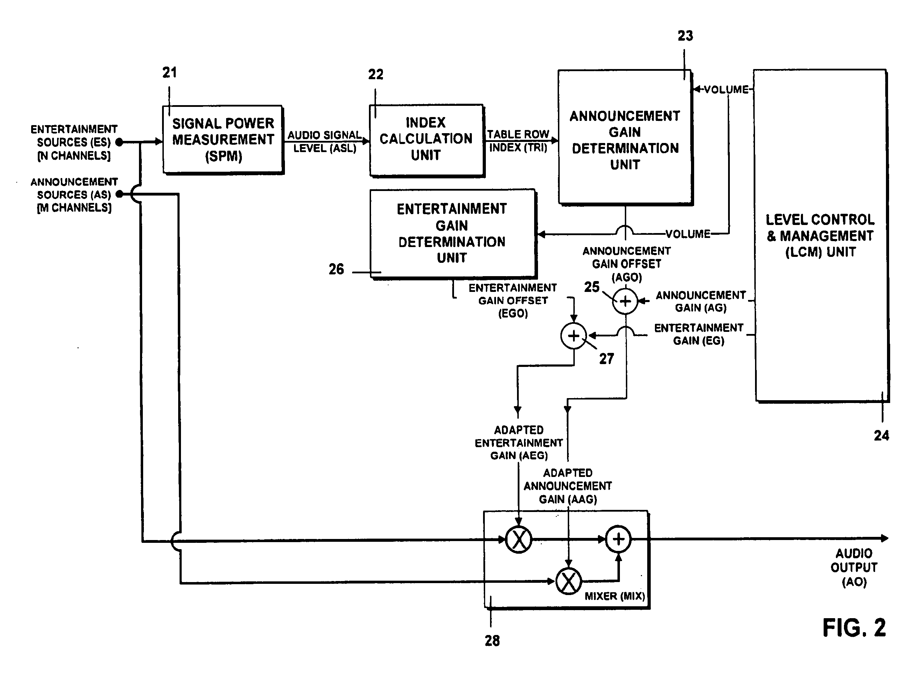

In Fig. 2 a system for automatically adjusting the entertainment sound signal relative to the announcement sound signal is shown in more detail. First of all, the entertainment sound signals which can be provided in N different channels are input to a signal power measurement unit 21 in which the maximum and the mean signal power of the entertainment signal is determined and in which the signal power is transferred into a loudness value based on a psycho acoustic model of human hearing. The maximum and the mean signal power is then fed to an index calculation unit 22. In unit 22 the signal course of the maximum and the mean signal power is evaluated and an average signal level is determined. Unit 22 helps to recognize whether the entertainment sound signal has a constant high signal level or whether the entertainment signal comprises short time maximums, as it is the case when a beat is contained in the signal. The determined index representing the average loudness of the entertainment signal is then fed to an announcement gain determination unit 23. It should be understood that the average loudness of the entertainment sound signal can be determined in any other way by other approximation methods known in the art. This announcement gain determination unit receives the adjusted volume from a level control and management unit 24, the volume representing the volume adjusted by the user of the system at a volume control button provided on the system. In most cases this button is a turn button or a rocker, and by turning the button to the right or to the left or by pushing one side of the rocker or the other the volume can be increased and decreased, respectively.

On the basis of the adjusted volume and the index the announcement gain determination unit determines the announcement gain offset (AGO). The announcement gain determination unit now determines the corrected announcement gain offset which might be positive or negative and describes a corrected announcement level. This announcement gain offset is then added to the actual announcement gain. The volume on the basis of which the announcement determination unit determines the announcement gain offset is a first value. The announcement gain (AG) itself is a second value between a minimum and maximum signal level of the announcement signal. When the announcement gain offset AGO is added to the announcement gain in the adder 25 the result is an adapted announcement gain (AAG).

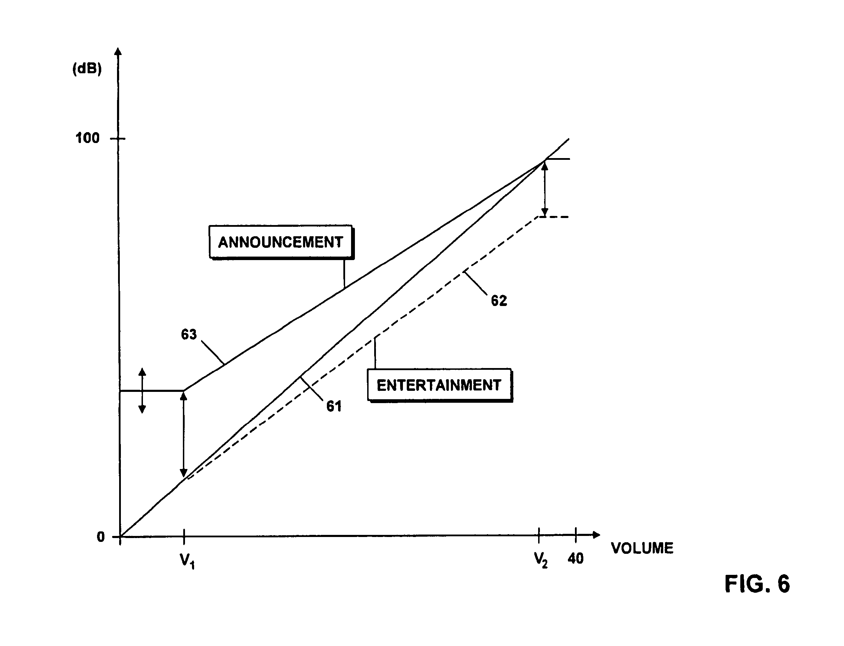

The adjusted volume is additionally output to an entertainment gain determination unit 26. The functioning of the entertainment gain determination unit can also be seen in Fig. 6. In Fig. 6 the signal level of the announcement signal and the entertainment signal can be seen. In Fig. 6 graph 61 shows the signal level of the entertainment signal in decibel in dependence on the adjusted volume adjusted at a volume control of the sound system for a fixed moment in time. Graph 61 is used when no announcement sound signal is present. In the case an announcement sound signal is present the graph 61 representing the entertainment sound signal is adapted to the dashed line 62 showing the signal level in decibel depending on the adjusted volume. The entertainment gain determination unit adjusts graph 61 to graph 62. The entertainment gain determination unit outputs an entertainment gain offset (EGO) which is added to the entertainment gain value (EG) in adder 27. The two added signals in adder 27 result in the adapted entertainment gain (AEG). This adapted entertainment gain is then mixed to the entertainment signal itself in mixer 28. Additionally, the adapted announcement gain AAG is mixed to the signal. Last but not least these two mixed signals are combined in the mixer 28 and output as an audio output comprising an entertainment component and an announcement component.

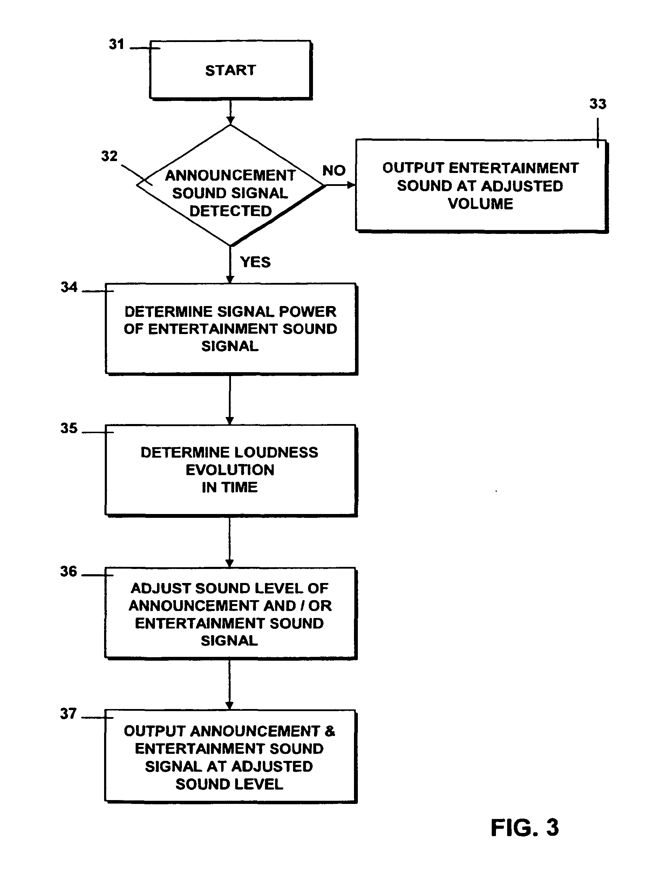

In Fig. 3 the different steps carried out are summarized. The method for adjusting the signal level starts in step 31 before it is asked whether an announcement sound signal can be detected in step 32. If no announcement sound signal is detected the entertainment sound signal is output at the adjusted volume (step 33). The system then returns to step 32 where it is asked whether an announcement sound signal is present. If, however, an announcement sound signal can be detected in step 32 the signal power of the entertainment sound signal is determined in step 34. On the basis of the determined signal power, the loudness evolution of the entertainment signal in time can be determined (step 35). In step 36 the loudness of the entertainment signal and of the announcement signal are adjusted relative to each other before the two signals are output in step 37.

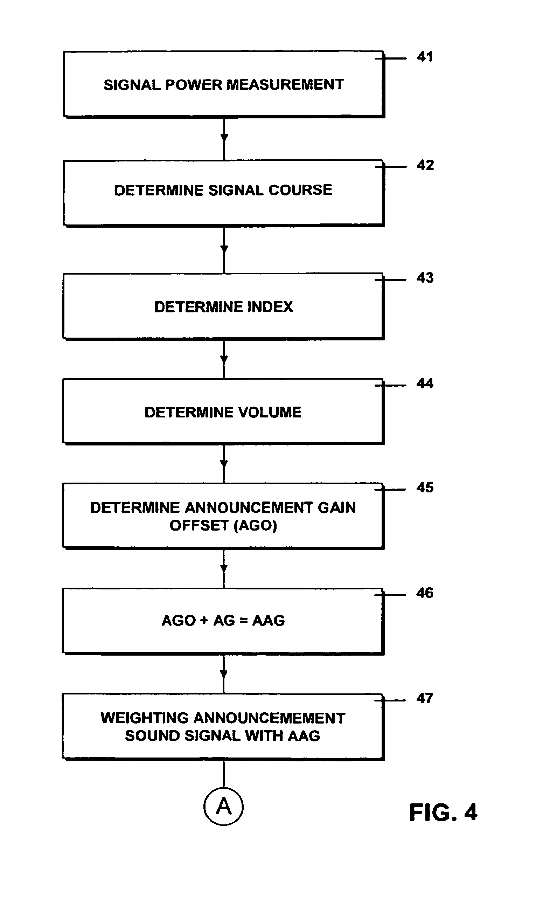

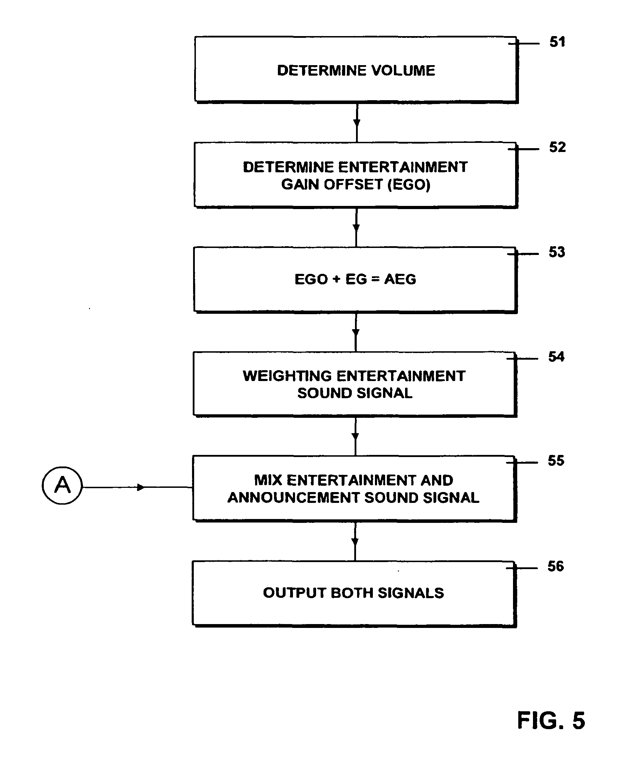

In Figs. 4 and 5 the steps carried out by the embodiment shown in Fig. 2 are shown in more detail.

For adjusting the announcement signal relative to this entertainment signal the signal power of the entertainment signal is measured in step 41. Next the signal course of the entertainment sound signal is evaluated in step 42, so that an index can be calculated representing the average loudness of the entertainment signal (step 43). Additionally, the volume adjusted at the volume control is determined in step 44. The index determined in step 43 and the volume determined in step 44 are used for determining the announcement gain offset in step 45. Once the announcement gain offset is determined it is added to the announcement gain resulting in the adapted announcement gain AAG (step 46). The announcement signal is then weighted with the adapted announcement gain in step 47.

In addition to the announcement signal the entertainment signal has to be adjusted, too. To this end the volume has to be determined in step 51. On the basis of the determined volume the entertainment gain offset can be determined in step 52. Furthermore, the entertainment gain offset is added to the actual entertainment gain resulting in the adapted entertainment gain (step 53). This adapted entertainment gain is used for weighting the entertainment signal in step 54. The two weighted signals, the weighted entertainment sound signal and the weighted announcement sound signal are then mixed together in step 55 before their output as audio output signal in step 56.

In Fig. 6 the signal course of the adapted entertainment signal and announcement signal are shown as a function of the adjusted volume. As was already explained in connection with Fig. 2, graph 61 shows the signal course of the entertainment signal when no announcement signal is present. In this case the sound level in decibel increases in a linear way with the adjusted volume. However, when an announcement sound signal is present in the audio output shown in Fig. 2 additionally a signal course of the announcement signal 63 is shown. As can be seen in Fig. 6 the announcement signal has a constant signal level up to a first threshold volume V1. If the adjusted volume of the entertainment sound signal is very low a constant signal level of the announcement source is maintained in order to make sure that the user can understand the announced information. With increasing volume the signal level of the announcement sound signal increases up to a second threshold V2. As can be seen from Fig. 6 between the first threshold V1 and the second threshold V2 the level difference between the two signals decreases.

With increasing volume the signal level of the entertainment signal is lowered as can be seen when comparing graphs 61 and 62. In order to avoid that the announcement becomes too loud the entertainment sound is lowered. Above the threshold V2 both signal are kept constant.

The embodiment shown in Fig. 6 shows the static behaviour of the two sound signals. As explained above, the graph 61 shows the normal relationship between the entertainment sound and the adjusted volume. The slope of the graphs 62 and 63 is determined in advance and depends on the vehicle. By way of example, the slope of the two graphs 62 and 63 may be determined by the car manufacturing company and depends on the type of vehicle. The difference between the two graphs 62 and 63 is determined by the end user and may be changed over a menu of the sound system. This adjustment of the two sound signals relative to each other reflects the fact, which kind of entertainment sound the user is hearing when he or she adjusts the loudness of the announcement sound.

According to the invention, the announcement sound signal is then changed in accordance with the loudness of the entertainment sound. This can be achieved by detecting the dynamic signal course of the entertainment sound signal which is used for determining the value AGO of Fig. 2 which is applied to the announcement sound signal without modulation the announcement sound signal. The value AAG of Fig. 2 corresponds to the relative distance of the graphs 62 and 63 on a time axis (e.g. the z-axis), which is not shown in the embodiment of Fig. 6. The actual signal course of AAG depends on the evolution in time of the entertainment sound signal, and is not a static value as it is the case in the prior art systems.

As can be seen from the above description the invention provides an effective adjustment of the two different sound signals relative to each other. In order to do so no microphones are needed for measuring the output entertainment signal, and no feedback control of the measured entertainment signal is necessary. The present invention only uses a psychoacoustic model of the human hearing for determining the different values.

## Claims

1. Sound system comprising:
- an entertainment sound source (10) generating an entertainment sound signal,
- an announcement sound source (11) generating an announcement sound signal,
- a sound emitting unit (15) for reproducing the entertainment and the announcement sound signal,
- a loudness determination unit for determining the loudness evolution in time of the entertainment sound signal,
- a control unit (13) for adjusting the loudness of the announcement sound signal relative to the loudness of the entertainment sound signal in accordance with the determined loudness evolution of the entertainment sound signal, wherein the announcement sound signal has the following characteristic:
- a minimum sound level up to a first threshold of the entertainment sound level, a constantly increasing sound level with increasing sound level of the entertainment sound level, the slope of the announcement sound signal being smaller than the slope of the entertainment sound signal, and a maximum sound level above a second threshold of the entertainment sound signal.

2. Sound system according to claim 1, **characterized by** further comprising an entertainment signal power measurement unit measuring the maximum and the mean power of the entertainment sound signal.

3. Sound system according to claim 1 or 2, **characterized in that** the loudness determination unit determines an index representing an average loudness of the entertainment sound signal based on a maximum and mean power of the entertainment sound signal.

4. Sound system according to any of the preceding claims, **characterized by** further comprising an announcement gain determination unit determining an announcement gain offset (AGO) of the announcement sound signal based on the index representing the average loudness of the entertainment sound signal and based on the volume adjustment of the entertainment sound signal.

5. Sound system according to claim 4, **characterized by** further comprising a first adder in which the announcement gain offset (AGO) of the announcement sound signal is added to an announcement gain (AG) for generating an adapted announcement gain (AAG).

6. Sound system according to any of the preceding claims, **characterized by** further comprising an entertainment gain determination unit determining an entertainment gain offset (EGO) of the entertainment sound signal based on the volume adjustment of the entertainment sound signal.

7. Sound system according to claim 6 **characterized by** further comprising a second adder in which the entertainment gain offset (EGO) is added to an entertainment gain (EG) for generating an adapted entertainment gain (AEG).

8. Sound system according to claim 5, **characterized by** further comprising a first mixer in which the adapted announcement gain (AAG) is mixed to the announcement sound signal.

9. Sound system according to claim 7, **characterized by** further comprising a second mixer in which the adapted entertainment gain (AEG) is mixed to the entertainment sound signal.

10. Sound system according to claim 8 and 9, **characterized by** further comprising a third adder in which the output signals of the first and the second mixer are combined for generating an audio output for the user of the sound system.

11. Sound system according to any of the preceding claims, **characterized in that** the entertainment sound signal comprises a sound signal from at least on of the following sound sources: optical, magnetic, or silicon-based media, and storage devices, or broadcast receiver.

12. Sound system according to any of the preceding claims, **characterized in that** the announcement sound signal comprises a voice signal of a navigation unit, a vehicle control unit, a Speech-Dialog-System, and/or a Text-To-Speech System.

13. Vehicle multimedia system comprising a sound system as described in any of claims 1 to 12.

14. Method for adjusting the loudness of an announcement sound signal relative to the loudness of an entertainment sound signal, comprising the following steps:
- detecting the presence of an announcement sound signal, and if an announcement sound signal has been detected, wherein the announcement sound signal has the following characteristic:
- a minimum sound level up to a first threshold of the entertainment sound level, a constantly increasing sound level with increasing sound level of the entertainment sound level, the slope of the announcement sound signal being smaller than the slope of the entertainment sound signal, and a maximum sound level above a second threshold of the entertainment sound signal,
- determining the loudness evolution of the entertainment sound signal in time,
- adjusting the loudness of the announcement sound signal relative to the loudness of the entertainment sound signal depending on the loudness evolution of the entertainment sound signal.

15. Method according to claim 14, **characterized by** further comprising the step of determining the signal power evolution of the entertainment sound signal in time.

16. Method according to claim 15, **characterized in that** the loudness evolution of the entertainment sound signal is determined based on the signal power evolution of the entertainment sound signal.

17. Method according to any of claims 14 to 16, **characterized by** further comprising the step of: determining an announcement gain offset (AGO) of the announcement sound signal relative to the entertainment sound signal.

18. Method according to claim 17, **characterized in that** the determination of the announcement gain offset (AGO) comprises at least the following steps:
- determining an index representing the average loudness of the entertainment sound signal,
- determining the volume adjustment for the entertainment sound signal, and
- determining the announcement gain offset (AGO) in accordance with the index and the volume adjustment.

19. Method according to claim 18, **characterized in that** the index is determined by analyzing the loudness evolution of the entertainment sound signal in time and determining an average loudness of the entertainment sound signal based on a maximum and mean power of the entertainment sound signal.

20. Method according to any of claims 17 to 19, **characterized by** further comprising the step of adding the announcement gain offset (AGO) to an announcement gain (AG) for generating an adapted announcement gain (AAG).

21. Method according to any of claims 14 to 20, **characterized by** further comprising the step of determining an entertainment gain offset (EGO) of the entertainment sound signal based on the volume adjustment of the entertainment sound signal.

22. Method according to any of claims 14 to 21, **characterized in that** the signal to noise ratio of the announcement sound signal relative to the entertainment sound signal decreases with increasing sound level of the entertainment sound.

23. Method according to any of claims 17 to 20, **characterized by** further comprising the step of adding the announcement gain offset (AGO) of the announcement sound signal to an announcement gain (AG) for generating an adapted announcement gain (AAG).

24. Method according to claim 21, **characterized by** further comprising the step of adding the entertainment gain offset (EGO) to an entertainment gain (EG) for generating an adapted entertainment gain (AEG).

25. Method according to claim 20 or claim 23, claim 20 or claim 23, **characterized by** further comprising the step of mixing the adapted announcement gain (AAG) to the announcement signal.

26. Method according to claim 24, **characterized by** further comprising the step of mixing the adapted entertainment gain (AEG) to the entertainment sound signal.

27. Method according to any of claims 14 to 26, **characterized in that** the sound level of the entertainment sound signal is decreased relative to the sound level resulting from the volume adjustment for the entertainment sound signal, the decrease increasing with increasing adjusted volume.

## Patentansprüche

1. Audiosystem, umfassend:
- eine Unterhaltungsschallquelle (10), die ein Unterhaltungsschallsignal generiert,
- eine Mitteilungsschallquelle (11), die ein Mitteilungsschallsignal generiert,
- eine Schall emittierende Einheit (15), um das Unterhaltungs- und das Mitteilungsschallsignal wiederzugeben,
- eine Lautstärke ermittelnde Einheit, um die Lautstärkeentwicklung des Unterhaltungsschallsignals im Zeitverlauf zu ermitteln,
- eine Steuereinheit (13), um die Lautstärke des Mitteilungsschallsignals relativ zu der Lautstärke des Unterhaltungsschallsignals gemäß der ermittelten Lautstärkeentwicklung des Unterhaltungsschallsignals einzustellen, wobei das Mitteilungsschallsignal die folgenden Merkmale aufweist:
- einen Mindestschallpegel bis zu einem ersten Schwellenwert des Unterhaltungsschallpegels, einen konstant zunehmenden Schallpegel mit zunehmendem Schallpegel des Unterhaltungsschallpegels, wobei die Steigung des Mitteilungsschallsignals kleiner als die Steigung des Unterhaltungsschallsignals ist, und einen Maximalschallpegel über einem zweiten Schwellenwert des Unterhaltungsschallsignals.

2. Audiosystem nach Anspruch 1, **dadurch gekennzeichnet, dass** es ferner eine Einheit zur Messung der Unterhaltungssignalleistung umfasst, die die maximale und die mittlere Leistung des Unterhaltungsschallsignals misst.

3. Audiosignal nach Anspruch 1 oder 2, **dadurch gekennzeichnet, dass** die Lautstärke ermittelnde Einheit einen Index ermittelt, der eine durchschnittliche Lautstärke des Unterhaltungsschallsignals basierend auf einer maximalen und einer mittleren Leistung des Unterhaltungsschallsignals repräsentiert.

4. Audiosystem nach einem der vorhergehenden Ansprüche, **dadurch gekennzeichnet, dass** es ferner eine Einheit zur Bestimmung der Mitteilungsverstärkung umfasst, die einen Mitteilungsverstärkungsausgleich (AGO) des Mitteilungsschallsignals basierend auf einem Index ermittelt, der die durchschnittliche Lautstärke des Unterhaltungsschallsignals repräsentiert und auf der Lautstärkeeinstellung des Unterhaltungsschallsignals basiert.

5. Audiosystem nach Anspruch 4, **dadurch gekennzeichnet, dass** es ferner einen ersten Addierer umfasst, in dem der Mitteilungsverstärkungsausgleich (AGO) des Mitteilungsschallsignals zu einer Mitteilungsverstärkung (AG) addiert wird, um eine adaptierte Mitteilungsverstärkung (AAG) zu generieren.

6. Audiosystem nach einem der vorhergehenden Ansprüche, **dadurch gekennzeichnet, dass** es ferner eine Einheit zum Ermitteln einer Unterhaltungsverstärkung umfasst, die einen Unterhaltungsverstärkungsausgleich (EGO) des Unterhaltungsschallsignals ermittelt, der auf der Lautstärkeeinstellung des Unterhaltungsschallsignals basiert.

7. Audiosystem nach Anspruch 6, **dadurch gekennzeichnet, dass** es ferner einen zweiten Addierer umfasst, in dem der Unterhaltungsverstärkungsausgleich (EGO) zu einer Unterhaltungsverstärkung (EG) addiert wird, um eine adaptierte Unterhaltungsverstärkung (AEG) zu generieren.

8. Audiosystem nach Anspruch 5, **dadurch gekennzeichnet, dass** es ferner einen ersten Mischer umfasst, in dem die adaptierte Mitteilungsverstärkung (AAG) mit dem Mitteilungsschallsignal gemischt wird.

9. Audiosystem nach Anspruch 7, **dadurch gekennzeichnet, dass** es ferner einen zweiten Mischer umfasst, in dem die adaptierte Unterhaltungsverstärkung (AEG) mit dem Unterhaltungsschallsignal gemischt wird.

10. Audiosystem nach Anspruch 8 und 9, **dadurch gekennzeichnet, dass** es ferner einen dritten Addierer umfasst, in dem die Ausgabesignale des ersten und des zweiten Mischers kombiniert werden, um eine Audioausgabe für den Nutzer des Audiosystems zu generieren.

11. Audiosystem nach einem der vorhergehenden Ansprüche, **dadurch gekennzeichnet, dass** das Unterhaltungsschallsignal ein Schallsignal aus mindestens einer der folgenden Schallquellen umfasst: optische, magnetische oder siliciumbasierte Medien und Speichergeräte oder Rundfunkempfänger.

12. Audiosystem nach einem der vorhergehenden Ansprüche, **dadurch gekennzeichnet, dass** das Mitteilungsschallsignal ein Sprachsignal aus einer Navigationseinheit, einer Fahrzeugsteuerungseinheit, einem Sprach-Dialog-System und/oder einem Text-zu-Sprache-System umfasst.

13. Fahrzeugmultimediasystem, das ein Audiosystem nach einem der Ansprüche 1 bis 12 umfasst.

14. Verfahren zum Einstellen der Lautstärke eines Mitteilungsschallsignals relativ zu der Lautstärke eines Unterhaltungsschallsignals, umfassend die folgenden Schritte:
- Erkennen der Anwesenheit eines Mitteilungsschallsignals, und falls ein Mittelungsschallsignal erkannt wurde, wobei dieses die folgenden Merkmale aufweist:
- einen Mindestschallpegel bis zu einem ersten Schwellenwert des Unterhaltungsschallpegels, einen konstant zunehmenden Schallpegel mit zunehmendem Schallpegel des Unterhaltungsschallpegels, wobei die Steigung des Mitteilungsschallsignals kleiner als die Steigung des Unterhaltungsschallsignals ist, und einen Maximalschallpegel über einem zweiten Schwellenwert des Unterhaltungsschallsignals,
- Ermitteln der Lautstärkeentwicklung des Unterhaltungsschallsignals im Zeitverlauf,
- Einstellen der Lautstärke des Mitteilungsschallsignals relativ zu der Lautstärke des Unterhaltungsschallsignals in Abhängigkeit von der Lautstärkeentwicklung des Unterhaltungsschallsignals.

15. Verfahren nach Anspruch 14, **dadurch gekennzeichnet, dass** es ferner den Schritt des Ermittelns der Signalleistungsentwicklung des Unterhaltungsschallsignals im Zeitverlauf umfasst.

16. Verfahren nach Anspruch 15, **dadurch gekennzeichnet, dass** die Lautstärkeentwicklung des Unterhaltungsschallsignals basierend auf der Signalleistungsentwicklung des Unterhaltungsschallsignals ermittelt wird.

17. Verfahren nach einem der Ansprüche 14 bis 16, **dadurch gekennzeichnet, dass** es ferner den folgenden Schritt umfasst: Ermitteln eines Mitteilungsverstärkungsausgleichs (AGO) des Mitteilungsschallsignals relativ zu dem Unterhaltungsschallsignal.

18. Verfahren nach Anspruch 17, **dadurch gekennzeichnet, dass** das Ermitteln des Mitteilungsverstärkungsausgleichs (AGO) mindestens die folgenden Schritte umfasst:
- Ermitteln eines Index, der die durchschnittliche Lautstärke des Unterhaltungsschallsignals repräsentiert,
- Ermitteln der Lautstärkeeinstellung des Unterhaltungsschallsignals und
- Ermitteln des Mitteilungsverstärkungsausgleichs (AGO) gemäß dem Index und der Lautstärkeeinstellung.

19. Verfahren nach Anspruch 18, **dadurch gekennzeichnet, dass** der Index ermittelt wird, indem die Lautstärkeentwicklung des Unterhaltungsschallsignals im Zeitverlauf analysiert wird und eine durchschnittliche Lautstärke des Unterhaltungsschallsignals basierend auf einer maximalen und mittleren Leistung des Unterhaltungsschallsignals ermittelt wird.

20. Verfahren nach einem der Ansprüche 17 bis 19, **dadurch gekennzeichnet, dass** es ferner den Schritt des Addierens des Mitteilungsverstärkungsausgleichs (AGO) zu einer Mitteilungsverstärkung (AG) umfasst, um eine adaptierte Mitteilungsverstärkung (AAG) zu generieren.

21. Verfahren nach einem der Ansprüche 14 bis 20, **dadurch gekennzeichnet, dass** es ferner den Schritt des Ermittelns eines Unterhaltungsverstärkungsausgleichs (EGO) des Unterhaltungsschallsignals basierend auf der Lautstärkeeinstellung des Unterhaltungsschallsignals umfasst.

22. Verfahren nach einem der Ansprüche 14 bis 21, **dadurch gekennzeichnet, dass** das Signal-zu-Rauschverhältnis des Mitteilungsschallsignals relativ zu dem Unterhaltungsschallsignal mit zunehmendem Schallpegel des Unterhaltungsschalls abnimmt.

23. Verfahren nach einem der Ansprüche 17 bis 20, **dadurch gekennzeichnet, dass** es ferner den Schritt des Addierens des Mitteilungsverstärkungsausgleichs (AGO) des Mitteilungsschallsignals zu einer Mitteilungsverstärkung (AG) umfasst, um eine adaptierte Mitteilungsverstärkung (AAG) zu generieren.

24. Verfahren nach Anspruch 21, **dadurch gekennzeichnet, dass** es ferner den Schritt des Addierens des Unterhaltungsverstärkungsausgleichs (EGO) zu einer Unterhaltungsverstärkung (EG) umfasst, um eine adaptierte Unterhaltungsverstärkung (AEG) zu generieren.

25. Verfahren nach Anspruch 20 oder Anspruch 23, **dadurch gekennzeichnet, dass** es ferner den Schritt des Mischens der adaptierten Mitteilungsverstärkung (AAG) zu dem Mitteilungssignal umfasst.

26. Verfahren nach Anspruch 24, **dadurch gekennzeichnet, dass** es ferner den Schritt des Mischens der adaptierten Unterhaltungsverstärkung (AEG) zu dem Unterhaltungsschallsignal umfasst.

27. Verfahren nach einem der Ansprüche 14 bis 26, **dadurch gekennzeichnet, dass** der Schallpegel des Unterhaltungsschallsignals relativ zu dem Schallpegel, der aus der Lautstärkeeinstellung des Unterhaltungsschallsignals resultiert, verringert wird, wobei die Verringerung mit zunehmender eingestellter Lautstärke zunimmt.

## Revendications

1. Système audio comprenant :
- une source sonore (10) de divertissement produisant un signal sonore de divertissement,
- une source sonore (11) d'annonce produisant un signal sonore d'annonce,
- une unité (15) d'émission sonore pour reproduire le divertissement et le signal sonore d'annonce,
- une unité de détermination du volume pour déterminer l'évolution du volume dans le temps du signal sonore de divertissement,
- une unité (13) de commande pour ajuster le volume du signal sonore d'annonce par rapport au volume du signal sonore de divertissement selon l'évolution déterminée de volume du signal sonore de divertissement, dans lequel le signal sonore d'annonce présente les caractéristiques suivantes :
- un niveau sonore minimal jusqu'à un premier seuil du niveau sonore de divertissement, un niveau sonore en constante augmentation lorsque le niveau sonore du niveau sonore de divertissement augmente, la pente du signal sonore d'annonce étant plus faible que la pente du signal sonore de divertissement, et un niveau sonore maximal se trouvant au-dessus d'un deuxième seuil du signal sonore de divertissement.

2. Système audio selon la revendication 1, **caractérisé en ce qu'**il comprend en outre une unité de mesure de puissance du signal de divertissement mesurant la puissance maximale et moyenne du signal sonore de divertissement.

3. Système audio selon la revendication 1 ou la revendication 2, **caractérisé en ce que** l'unité de détermination du volume détermine un indice représentant un volume moyen du signal sonore de divertissement en fonction d'une puissance maximale et moyenne du signal sonore de divertissement.

4. Système audio selon l'une quelconque des revendications précédentes, **caractérisé en ce qu'**il comprend en outre une unité de détermination du gain d'annonce déterminant un décalage de gain d'annonce (AGO) du signal sonore d'annonce en fonction de l'indice représentant le volume moyen du signal sonore de divertissement et baser sur le réglage du volume du signal sonore de divertissement.

5. Système audio selon la revendication 4, **caractérisé en outre en ce qu'**il comprend en outre un premier additionneur dans lequel le décalage du gain d'annonce (AGO) du signal sonore d'annonce est ajoutée à un gain d'annonce (AG) pour produire un gain d'annonce adapté (AAG).

6. Système audio selon l'une quelconque des revendications précédentes, **caractérisé en ce qu'**il comprend en outre une unité de détermination de gain de divertissement déterminant une compensation de gain de divertissement (EGO) du signal sonore de divertissement en fonction du réglage du volume du signal sonore de divertissement.

7. Système audio selon la revendication 6 **caractérisé en ce qu'**il comprend en outre un deuxième additionneur dans lequel le décalage de gain de divertissement (EGO) est ajouté à un gain de divertissement (EG) pour produire un gain de divertissement adapté (AEG).

8. Système audio selon la revendication 5, **caractérisé en ce qu'**il comprend en outre un mixeur dans lequel le gain d'annonce adapté (AAG) est mixé au signal sonore d'annonce.

9. Système audio selon la revendication 7, **caractérisé en ce qu'**il comprend en outre un deuxième mixeur dans lequel le gain de divertissement adapté (AEG) est mixé au signal sonore de divertissement.

10. Système audio selon la revendication 8 et la revendication 9, **caractérisé en ce qu'**il comprend en outre un troisième additionneur dans lequel les signaux de sortie du premier mixeur et du deuxième mixeur sont combinés pour produire un signal de sortie audio pour l'utilisateur du système audio.

11. Système audio selon l'une quelconque des revendications précédentes, **caractérisé en ce que** le signal audio de divertissement comprend un signal audio d'au moins l'une des sources sonores suivantes : optique, magnétique ou un support à base de silicium, et des périphériques de stockage ou un appareil récepteur de radiodiffusion.

12. Système audio selon l'une quelconque des revendications précédentes, **caractérisé en ce que** le signal sonore d'annonce comprend un signal vocal d'une unité de navigation, une unité de commande de véhicule, un système de reconnaissance vocale, et/ou un système de synthèse vocale.

13. Système multimédia de véhicule comprenant un système audio selon l'une quelconque des revendications 1 à 12.

14. Procédé de réglage du volume d'un signal sonore d'annonce par rapport au volume d'un signal sonore de divertissement, comprenant les étapes suivantes :
- détection de la présence d'un signal sonore d'annonce, et en cas de détection d'un signal sonore d'annonce, dans lequel le signal sonore d'annonce présente les caractéristiques suivantes :
- un niveau sonore minimal jusqu'à un premier seuil du niveau sonore de divertissement, un niveau sonore en constante augmentation lorsque le niveau sonore du niveau sonore de divertissement augmente, la pente du signal sonore d'annonce étant plus faible que la pente du signal sonore de divertissement, et un niveau sonore maximal se trouvant au-dessus d'un deuxième seuil du signal sonore de divertissement,
- détermination de l'évolution du volume du signal sonore de divertissement dans le temps,
- réglage du volume du signal sonore d'annonce par rapport au volume du signal sonore de divertissement selon l'évolution du volume sonore du signal sonore de divertissement.

15. Procédé selon la revendication 14, **caractérisé en ce qu'**il comprend en outre l'étape consistant à déterminer l'évolution de puissance du signal du signal sonore de divertissement dans le temps.

16. Procédé selon la revendication 15, **caractérisé en ce que** l'évolution du volume du signal sonore de divertissement est déterminée en fonction de l'évolution de puissance du signal du signal sonore de divertissement.

17. Procédé selon l'une quelconque des revendications 14 à 16, **caractérisé en ce qu'**il comprend en outre l'étape consistant à : déterminer un décalage de gain d'annonce (AGO) du signal sonore d'annonce par rapport au signal sonore de divertissement.

18. Procédé selon la revendication 17, **caractérisé en ce que** la détermination du décalage de gain d'annonce (AGO) comprend au moins les étapes consistant à :
- déterminer un indice représentant le volume moyen du signal sonore de divertissement,
- déterminer le réglage de volume pour le signal sonore de divertissement, et
- déterminer le décalage de gain d'annonce (AGO) selon le réglage de l'indice et du volume.

19. Procédé selon la revendication 18, **caractérisé en ce que** l'indice est déterminé en analysant l'évolution du volume du signal sonore de divertissement dans le temps et à déterminer un volume moyen du signal sonore de divertissement en fonction d'une puissance maximale et moyenne du signal sonore de divertissement.

20. Procédé selon l'une quelconque des revendications 17 à 19, **caractérisé en ce qu'**il comprend en outre l'étape consistant à ajouter le décalage de gain d'annonce (AGO) à un gain d'annonce (AG) pour produire un gain d'annonce adapté (AAG).

21. Procédé selon l'une quelconque des revendications 14 à 20, **caractérisé en ce qu'**il comprend en outre l'étape consistant à déterminer un décalage de gain de divertissement (EGO) du signal sonore de divertissement en fonction du réglage de volume du signal sonore de divertissement.

22. Procédé selon l'une quelconque des revendications 14 à 21, **caractérisé en ce que** le ratio signal - bruit du signal sonore d'annonce par rapport au signal sonore de divertissement diminue lorsque le niveau sonore du son de divertissement augmente.

23. Procédé selon l'une quelconque des revendications 17 à 20, **caractérisé en ce qu'**il comprend en outre l'étape consistant à ajouter le décalage de gain d'annonce (AGO) du signal sonore d'annonce à un gain d'annonce (AG) pour produire un gain d'annonce adapté (AAG).

24. Procédé selon la revendication 21, **caractérisé en ce qu'**il comprend en outre l'étape consistant à ajouter le décalage de gain de divertissement (EGO) à un gain de divertissement (EG) pour produire un gain de divertissement adapté (AEG).

25. Procédé selon la revendication 20 ou la revendication 23, **caractérisé en ce qu'**il comprend en outre l'étape consistant à mixer le gain d'annonce adapté (AAG) au signal d'annonce.

26. Procédé selon la revendication 24, **caractérisé en ce qu'**il comprend en outre l'étape consistant à mixer le gain de divertissement adapté (AEG) au signal sonore de divertissement.

27. Procédé selon l'une quelconque des revendications 14 à 26, **caractérisé en ce que** le niveau sonore du signal sonore de divertissement diminue par rapport au niveau sonore résultant du réglage de volume pour le signal sonore de divertissement, la diminution s'intensifiant lorsque le volume réglé augmente.
